# EUROPÄISCHE PATENTSCHRIFT

(11) **EP 2 909 937 B1**
(45) Veröffentlichungstag und Bekanntmachung des Hinweises auf die Patenterteilung: **24.06.2020**
(21) Anmeldenummer: 13776815.6
(22) Anmeldetag: 15.10.2013
(51) Int. Cl.: H03K 17/18, H01H 47/00, H02M 1/32, H02H 7/10, H02M 1/08

(54) **VERFAHREN UND SCHALTUNGSEINHEIT ZUM ERMITTELN VON FEHLERZUSTÄNDEN EINER HALBBRÜCKENSCHALTUNG**
METHOD AND CIRCUIT UNIT FOR DETERMINING FAULT STATES IN A HALF-BRIDGE CIRCUIT
PROCÉDÉ ET MODULE DE CIRCUIT PERMETTANT DE DÉTERMINER DES ÉTATS DE DÉFAUT D'UN CIRCUIT DEMI-PONT

(30) Priorität: 22.10.2012 DE 102012219243
(43) Veröffentlichungstag der Anmeldung: 26.08.2015
(73) Patentinhaber: Conti Temic Microelectronic GmbH, 90411 Nürnberg (DE)
(72) Erfinder: HORNSTEIN, Christoph, 90461 Nürnberg (DE); BLEY, Ulrich, 04519 Rackwitz (DE); KÜHNEN, Kai, 90491 Nürnberg (DE)
(74) Vertreter: Bonn, Roman Klemens
(86) Internationale Anmeldenummer: PCT/EP2013/071502
(87) Internationale Veröffentlichungsnummer: WO 2014/063955

(56) Entgegenhaltungen:
- EP-A2- 0 388 850
- GB-A- 2 429 347
- US-A- 5 119 312
- US-A1- 2004 263 201
- US-A1- 2012 181 961
- US-B2- 6 851 077
- VAN DEN KEYBUS J ET AL: "Protection of digitally controlled inverter units in rapid prototyping applications", APPLIED POWER ELECTRONICS CONFERENCE AND EXPOSITION, 2005. APEC 2005. TWENTIETH ANNUAL IEEE AUSTIN, TX, USA 6-10 MARCH 2005, PISCATAWAY, NJ, USA,IEEE, US, Bd. 2, 6. März 2005 (2005-03-06), Seite 1105, XP010809434, DOI: 10.1109/APEC.2005.1453134 ISBN: 978-0-7803-8975-5

## Beschreibung

Die Erfindung betrifft ein Verfahren und eine Schaltungseinheit zum Ermitteln von Fehlerzuständen einer, zumindest einen ersten Halbleiterschalter und einen zweiten Halbleiterschalter aufweisenden Halbbrückenschaltung.

Aus der DE 43 01 605 C1 sind ein Verfahren und eine Anordnung zum Überwachen des Ein- und Ausschaltens eines steuerbaren Leistungshalbleiterbauelements in einer leistungselektronischen Schaltung bekannt. Steuersignale für das Leistungshalbleiterbauelement werden einer Gate-Elektrode galvanisch entkoppelt zugeführt. Bei einem Ansteuerungssignal zur Einschaltung des Leistungshalbleiterbauelements werden aus Pegelwechseln des die Gate-Elektrode beaufschlagenden Signals und den Pegelwechseln an einer Ausgangselektrode beim Umschalten des Leistungshalbleiterbauelements Zählsignale gebildet. Die Zählsignale werden aufsummiert und mit einem der einwandfreien Arbeitsweise des Leistungshalbleiterbauelements zugeordneten, vorgegebenen Zählwert verglichen. Bei einem Unterschied zwischen der Summe der Zählsignale und dem vorgegebenen Zählwert wird ein Fehler gemeldet.

Das Dokument GB 2 429 347 A offenbart ein weiteres Verfahren und eine weitere Anordnung zum Überwachen eines steuerbaren Leistungshalbleiterbauelements.

Aufgabe der Erfindung ist es, ein Verfahren und eine Schaltungseinheit zum Ermitteln von Fehlerzuständen einer, zumindest einen ersten Halbleiterschalter und einen zweiten Halbleiterschalter aufweisenden Halbbrückenschaltung anzugeben, welche eine erhöhte Betriebssicherheit für den Betrieb der Halbbrückenschaltung ermöglichen.

Diese Aufgabe wird mit dem Gegenstand der unabhängigen Ansprüche gelöst. Vorteilhafte Weiterbildungen ergeben sich aus den abhängigen Ansprüchen.

Ein Verfahren zum Ermitteln von Fehlerzuständen einer, zumindest einen ersten Halbleiterschalter und einen zweiten Halbleiterschalter aufweisenden Halbbrückenschaltung, wobei der erste Halbleiterschalter und der zweite Halbleiterschalter zueinander in einer Reihenschaltung geschaltet und mittels jeweils eines Steuersignals, insbesondere eines pulsweiten modulierten Steuersignals, steuerbar sind und wobei der erste Halbleiterschalter und der zweite Halbleiterschalter jeweils einen geöffneten und einen geschlossenen Schaltzustand einnehmen können, weist gemäß einem Aspekt der Erfindung folgende Schritte auf. Es erfolgt ein Ermitteln eines Ist-Schaltzustands und eines Soll-Schaltzustands des ersten Halbleiterschalters. Zudem erfolgt ein Ermitteln eines Ist-Schaltzustands und eines Soll-Schaltzustands des zweiten Halbleiterschalters. Ferner erfolgt ein Erkennen eines Brückenkurzschlusses bei der Halbbrückenschaltung, falls der Ist-Schaltzustand des ersten Halbleiterschalters von dem Soll-Schaltzustand des ersten Halbleiterschalters verschieden ist und zudem der Ist-Schaltzustand des zweiten Halbleiterschalters von dem Soll-Schaltzustand des zweiten Halbleiterschalters verschieden ist.

Dabei wird hier und im Folgenden unter einem Brückenkurzschluss ein elektrischer Kurzschluss in der Laststrecke durch den ersten und den zweiten Halbleiterschalter verstanden. Ferner wird unter dem geschlossenen Schaltzustand ein Zustand des jeweiligen Halbleiterschalters verstanden, bei welchem ein elektrisch leitender Kanal und damit eine elektrische Verbindung über den Halbleiterschalter ausgebildet ist. Entsprechend wird unter dem geöffneten Schaltzustand ein Zustand des jeweiligen Halbleiterschalters verstanden, bei welchem kein elektrisch leitender Kanal und damit keine elektrische Verbindung über den Halbleiterschalter ausgebildet ist.

Das Verfahren gemäß der genannten Ausführungsform ermöglicht eine erhöhte Betriebssicherheit für den Betrieb der Halbbrückenschaltung. Dies erfolgt insbesondere durch das Erkennen eines Brückenkurzschlusses bei der Halbbrückenschaltung, falls der Ist-Schaltzustand des ersten Halbleiterschalters von dem Soll-Schaltzustand des ersten Halbleiterschalters verschieden ist und zudem der Ist-Schaltzustand des zweiten Halbleiterschalters von dem Soll-Schaltzustand des zweiten Halbleiterschalters verschieden ist. Es wird somit ein Brückenkurzschluss bei der Halbbrückenschaltung erkannt, falls ermittelt wird, dass der momentane Ist-Schaltzustand des ersten Halbleiterschalters von dem momentanen Soll-Schaltzustand des ersten Halbleiterschalters verschieden ist und zudem der momentane Ist-Schaltzustand des zweiten Halbleiterschalters von dem momentanen Soll-Schaltzustand des zweiten Halbleiterschalters verschieden ist. Beide Halbleiterschalter der Halbbrückenschaltung nehmen somit nicht den jeweiligen Soll-Schaltzustand ein. Dabei wird von der Überlegung ausgegangen, dass lediglich bei einem Brückenkurzschluss sowohl der erste Halbleiterschalter als auch der zweite Halbleiterschalter nicht den entsprechenden Soll-Schaltzustand einnehmen, wie im folgenden näher erläutert wird. Damit kann mittels des genannten Verfahrens in einem derartigen Fall in zuverlässiger Weise auf das Vorliegen eines Brückenkurzschlusses geschlossen werden. Ferner können dadurch Sicherheitsanforderungen für sicherheitsrelevante elektrische beziehungsweise elektronische Systeme insbesondere in Fahrzeug-Applikationen erfüllt werden, welche eine Unterscheidung eines Brückenkurzschlusses von weiteren Fehlerzuständen, die lediglich jeweils einen der Halbleiterschalter betreffen, erfordern, wie ebenfalls im Folgenden näher erläutert wird. Das Ermitteln des Ist-Schaltzustands und des Soll-Schaltzustands des ersten Halbleiterschalters erfolgt dabei in einem zeitlichen Zusammenhang zu dem Ermitteln des Ist-Schaltzustands und des Soll-Schaltzustands des zweiten Halbleiterschalters. Beispielsweise erfolgt das Ermitteln des Ist-Schaltzustands und des Soll-Schaltzustands des ersten Halbleiterschalters im Wesentlichen gleichzeitig mit dem Ermitteln des Ist-Schaltzustands und des Soll-Schaltzustands des zweiten Halbleiterschalters und damit ein Erkennen eines Brückenkurzschlusses bei der Halbbrückenschaltung, falls der Ist-Schaltzustand des ersten Halbleiterschalters von dem Soll-Schaltzustand des ersten Halbleiterschalters verschieden ist und zugleich der Ist-Schaltzustand des zweiten Halbleiterschalters von dem Soll-Schaltzustand des zweiten Halbleiterschalters verschieden ist.

Der Soll-Schaltzustand eines Halbleiterschalters des ersten und zweiten Halbleiterschalters ist dabei in einer Ausgestaltung geschlossen und der Soll-Schaltzustand des weiteren Halbleiterschalters des ersten und zweiten Halbleiterschalters geöffnet. Ein Brückenkurzschluss bei der Halbbrückenschaltung wird dabei erkannt, falls der Ist-Schaltzustand des in dem Soll-Schaltzustand geschlossenen Halbleiterschalters geöffnet ist und zudem der Ist-Schaltzustand des in dem Soll-Schaltzustand geöffneten Halbleiterschalters geschlossen ist. Der Ist-Schaltzustand des in dem Soll-Schaltzustand geöffneten Halbleiterschalters ist dabei beispielsweise auf Grund eines sogenannten Durchlegierens des Halbleiterschalters weiterhin geschlossen. Wird der weitere Halbleiterschalter in diesem Fall geschlossen und damit ein Brückenkurzschluss erzeugt, kann dieser den auftretenden hohen Kurzschlussstrom nicht tragen und geht daher wieder in den geöffneten Schaltzustand über. Somit kann in einem derartigen Fall wiederum auf das Vorliegen eines Brückenkurzschlusses geschlossen werden.

Zudem wird bevorzugt eine Anzahl der erkannten Brückenkurzschlüsse ermittelt. Falls die ermittelte Anzahl der erkannten Brückenkurzschlüsse einen vorgegebenen Schwellenwert überschreitet, werden der erste Halbleiterschalter und der zweite Halbleiterschalter und damit die Halbbrückenschaltung in einen vorgegebenen Betriebszustand geschaltet. Bevorzugt werden der erste Halbleiterschalter und der zweite Halbleiterschalter dabei geöffnet und damit die Halbbrückenschaltung typischerweise dauerhaft in einen ausgeschalteten Betriebszustand geschaltet.

In einer weiteren Ausführungsform des Verfahrens ist der erste Halbleiterschalter mittels einer ersten Schaltungsanordnung und der zweite Halbleiterschalter mittels einer zweiten Schaltungsanordnung ansteuerbar. Das Ermitteln des Ist-Schaltzustands des ersten Halbleiterschalters erfolgt in der genannten Ausführungsform mittels der ersten Schaltungsanordnung und das Ermitteln des Ist-Schaltzustands des zweiten Halbleiterschalters mittels der zweiten Schaltungsanordnung.

Der Ist-Schaltzustand des ersten Halbleiterschalters wird dabei bevorzugt mittels eines ersten Signals über eine erste Signalleitung von der ersten Schaltungsanordnung an eine zentrale Steuereinheit der Halbbrückenschaltung übermittelt. Ferner wird der Ist-Schaltzustand des zweiten Halbleiterschalters mittels eines zweiten Signals über eine zweite Signalleitung von der zweiten Schaltungsanordnung an die zentrale Steuereinheit übermittelt. Das Erkennen des Brückenkurzschlusses erfolgt in der genannten Ausgestaltung des Verfahrens mittels der zentralen Steuereinheit basierend auf dem übermittelten ersten und zweiten Signal.

Mittels der zentralen Steuereinheit wird in einer weiteren Ausführungsform des Verfahrens zudem ein Fehlerzustand ausschließlich des ersten Halbleiterschalters erkannt, falls der Ist-Schaltzustand des ersten Halbleiterschalters von dem Soll-Schaltzustand des ersten Halbleiterschalters verschieden ist und zudem der Ist-Schaltzustand des zweiten Halbleiterschalters dem Soll-Schaltzustand des zweiten Halbleiterschalters entspricht. Ferner wird mittels der zentralen Steuereinheit ein Fehlerzustand ausschließlich des zweiten Halbleiterschalters erkannt, falls der Ist-Schaltzustand des zweiten Halbleiterschalters von dem Soll-Schaltzustand des zweiten Halbleiterschalters verschieden ist und zudem der Ist-Schaltzustand des ersten Halbleiterschalters dem Soll-Schaltzustand des ersten Halbleiterschalters entspricht. Damit können in einfacher Weise, Einzelfehler des ersten Halbleiterschalters beziehungsweise des zweiten Halbleiterschalters von einem Fehlerzustand der Halbbrückenschaltung in Form eines Brückenkurzschlusses, bei welchem beide Halbleiterschalter gemeinsam einen Fehlerzustand aufweisen, unterschieden werden. Die jeweiligen Fehlerzustände werden dabei basierend auf dem ersten beziehungsweise dem zweiten, an die zentrale Steuereinheit übermittelten Signal erkannt. Somit ermöglicht die genannte Ausführungsform in vorteilhafter Weise eine Unterscheidung der genannten Fehlerzustände basierend auf lediglich jeweils einem Signal pro Halbleiterschalter.

Zudem wird bevorzugt eine Schalt-Anforderung der zentralen Steuereinheit für ein Schalten eines momentan geöffneten Halbleiterschalters des ersten und zweiten Halbleiterschalters in den geschlossenen Schaltzustand an die Schaltungsanordnung des zu schaltenden Halbleiterschalters gesendet. Nach dem Empfangen der Schalt-Anforderung durch die Schaltungsanordnung des zu schaltenden Halbleiterschalters wird dabei eine erste Zeitmessung einer Zeitmesseinheit der Schaltungsanordnung des zu schaltenden Halbleiterschalters gestartet und der Ist-Schaltzustand des zu schaltenden Halbleiterschalters nach dem Start der ersten Zeitmessung beispielsweise kontinuierlich ermittelt. Ferner wird der ermittelte Ist-Schaltzustand nach einer vorbestimmten Dauer nach dem Start der ersten Zeitmessung über die Signalleitung des zu schaltenden Halbleiterschalters an die zentrale Steuereinheit übermittelt.

In einer weiteren Ausgestaltung des Verfahrens wird zudem eine zweite Zeitmessung einer zweiten Zeitmesseinheit der zentralen Steuereinheit gestartet, sobald die Schalt-Anforderung der zentralen Steuereinheit erfolgt ist. In der genannten Ausgestaltung wird darüber hinaus ermittelt, ob der an die zentrale Steuereinheit übermittelte Ist-Schaltzustand des zu schaltenden Halbleiterschalters innerhalb eines vorbestimmten Zeitintervalls nach dem Start der zweiten Zeitmessung von dem geöffneten Schaltzustand in den geschlossenen Schaltzustand wechselt.

Von der zentralen Steuereinheit wird dabei ein Fehlerzustand erkannt, falls der an die zentrale Steuereinheit übermittelte Ist-Schaltzustand nicht innerhalb des vorbestimmten Zeitintervalls nach dem Start der zweiten Zeitmessung von dem geöffneten Schaltzustand in den geschlossenen Schaltzustand wechselt.

Insbesondere wird von der zentralen Steuereinheit ein Fehlerzustand der Zeitmesseinheit der Schaltungsanordnung des zu schaltenden Halbleiterschalters erkannt, falls der an die zentrale Steuereinheit übermittelte Ist-Schaltzustand vor Beginn des vorbestimmten Zeitintervalls nach dem Start der zweiten Zeitmessung von dem geöffneten Schaltzustand in den geschlossenen Schaltzustand wechselt.

Mittels der letztgenannten Ausführungsformen kann damit in vorteilhafter Weise insbesondere eine Drift der Zeitmesseinheit der Schaltungsanordnung des zu schaltenden Halbleiterschalters ermittelt werden, wie im Folgenden weiter erläutert wird.

Die Erfindung betrifft zudem eine Schaltungseinheit zum Ermitteln von Fehlerzuständen einer, zumindest einen ersten Halbleiterschalter und einen zweiten Halbleiterschalter aufweisenden Halbbrückenschaltung, wobei der erste Halbleiterschalter und der zweite Halbleiterschalter zueinander in einer Reihenschaltung geschaltet sind und jeweils einen geöffneten und einen geschlossenen Schaltzustand einnehmen können. Die Schaltungseinheit weist eine erste Ermittlungseinheit zum Ermitteln eines Ist-Schaltzustands des ersten Halbleiterschalters und eine zweite Ermittlungseinheit zum Ermitteln eines Ist-Schaltzustands des zweiten Halbleiterschalters auf. Zudem weist die Schaltungseinheit eine zentrale Steuereinheit zum Ermitteln eines Soll-Schaltzustands des ersten Halbleiterschalters und eines Soll-Schaltzustands des zweiten Halbleiterschalters und zum Ansteuern des ersten Halbleiterschalters und des zweiten Halbleiterschalters mittels jeweils eines Steuersignals, insbesondere eines pulsweiten modulierten Steuersignals, auf. Darüber hinaus weist die Schaltungseinheit eine Fehler-Ermittlungseinheit auf zum Erkennen eines Brückenkurzschlusses bei der Halbbrückenschaltung, falls der Ist-Schaltzustand des ersten Halbleiterschalters von dem Soll-Schaltzustand des ersten Halbleiterschalters verschieden ist und zudem der Ist-Schaltzustand des zweiten Halbleiterschalters von dem Soll-Schaltzustand des zweiten Halbleiterschalters verschieden ist.

Die Schaltungseinheit weist die bereits im Zusammenhang mit dem entsprechenden Verfahren genannten Vorteile auf, welche an dieser Stelle zur Vermeidung von Wiederholungen nicht nochmals aufgeführt werden.

In einer Ausführungsform weist die Schaltungseinheit weiterhin eine erste Schaltungsanordnung zum Ansteuern des ersten Halbleiterschalters auf, wobei die erste Schaltungsanordnung die erste Ermittlungseinheit aufweist. Ferner weist die Schaltungseinheit eine zweite Schaltungsanordnung zum Ansteuern des zweiten Halbleiterschalters auf, wobei die zweite Schaltungsanordnung die zweite Ermittlungseinheit aufweist. Der Ist-Schaltzustand des ersten Halbleiterschalters ist dabei mittels eines ersten Signals über eine erste Signalleitung von der ersten Schaltungsanordnung an die zentrale Steuereinheit übermittelbar. Ferner ist der Ist-Schaltzustand des zweiten Halbleiterschalters mittels eines zweiten Signals über eine zweite Signalleitung von der zweiten Schaltungsanordnung an die zentrale Steuereinheit übermittelbar. Die zentrale Steuereinheit weist in der genannten Ausführungsform die Fehler-Ermittlungseinheit auf und ist zum Erkennen des Brückenkurzschlusses basierend auf dem ersten und zweiten Signal ausgebildet.

Die zentrale Steuereinheit ist weiterhin bevorzugt zum Erkennen eines Fehlerzustands des ersten Halbleiterschalters ausgebildet, falls der Ist-Schaltzustand des ersten Halbleiterschalters von dem Soll-Schaltzustand des ersten Halbleiterschalters verschieden ist und zudem der Ist-Schaltzustand des zweiten Halbleiterschalters dem Soll-Schaltzustand des zweiten Halbleiterschalters entspricht. Ferner ist die zentrale Steuereinheit zum Erkennen eines Fehlerzustands des zweiten Halbleiterschalters ausgebildet, falls der Ist-Schaltzustand des zweiten Halbleiterschalters von dem Soll-Schaltzustand des zweiten Halbleiterschalters verschieden ist und zudem der Ist-Schaltzustand des ersten Halbleiterschalters dem Soll-Schaltzustand des ersten Halbleiterschalters entspricht.

In einer weiteren Ausführungsform weist die Schaltungseinheit zudem eine erste Zeitmesseinheit auf zum Starten einer ersten Zeitmessung nach einem Empfangen einer Schalt-Anforderung der zentralen Steuereinheit durch die erste Schaltungsanordnung für ein Schalten des ersten Halbleiterschalters in den geschlossenen Schaltzustand. Darüber hinaus weist die Schaltungseinheit eine zweite Zeitmesseinheit auf zum Starten einer zweiten Zeitmessung, sobald eine Schalt-Anforderung der zentralen Steuereinheit für ein Schalten des ersten Halbleiterschalters oder des zweiten Halbleiterschalters in den geschlossenen Schaltzustand erfolgt ist. Ferner weist die Schaltungseinheit eine dritte Zeitmesseinheit auf zum Starten einer dritten Zeitmessung nach einem Empfangen einer Schalt-Anforderung der zentralen Steuereinheit durch die zweite Schaltungsanordnung für ein Schalten des zweiten Halbleiterschalters in den geschlossenen Schaltzustand. Der Ist-Schaltzustand des ersten Halbleiterschalters ist dabei nach einer vorbestimmten Dauer nach dem Start der ersten Zeitmessung mittels des ersten Signals über die erste Signalleitung von der ersten Schaltungsanordnung an die zentrale Steuereinheit übermittelbar. Zudem ist der Ist-Schaltzustand des zweiten Halbleiterschalters nach einer vorbestimmten Dauer nach dem Start der dritten Zeitmessung mittels des zweiten Signals über die zweite Signalleitung von der zweiten Schaltungsanordnung an die zentrale Steuereinheit übermittelbar.

Die zentrale Steuereinheit ist in einer weiteren Ausgestaltung zum Erkennen eines Fehlerzustands ausgebildet, falls der an die zentrale Steuereinheit übermittelte Ist-Schaltzustand des ersten Halbleiterschalters oder des zweiten Halbleiterschalters nicht innerhalb eines vorbestimmten Zeitintervalls nach dem Start der zweiten Zeitmessung von dem geöffneten Schaltzustand in den geschlossenen Schaltzustand wechselt.

Der erste Halbleiterschalter und der zweite Halbleiterschalter sind beispielsweise als IGBT, insbesondere als n-Kanal IGBT, oder als MOSFET, insbesondere als n-Kanal MOSFET, ausbildet.

Ferner betrifft die Erfindung einen Stromrichter zum Bereitstellen von zumindest einem Phasenstrom für eine elektrische Maschine, wobei der Stromrichter eine Schaltungseinheit gemäß der genannten Ausführungsformen zum Bereitstellen des Phasenstromes aufweist.

Die Erfindung betrifft darüber hinaus eine Antriebsvorrichtung zum Antreiben eines Fahrzeugs mit einer elektrischen Maschine, wobei die Antriebsvorrichtung eine Schaltungseinheit gemäß der genannten Ausführungsformen zum Bereitstellen von zumindest einem Phasenstrom für die elektrische Maschine aufweist.

Ausführungsformen der Erfindung werden nun anhand der beigefügten Figuren näher erläutert.
- Figur 1A: zeigt eine Antriebsvorrichtung zum Antrieb eines Elektro- oder Hybridfahrzeugs mit einer elektrischen Maschine und einem Stromrichter in einer schematischen Darstellung gemäß einer Ausführungsform;
- Figur 1B: zeigt eine Schaltungseinheit zum Ermitteln von Fehlerzuständen einer Halbbrückenschaltung gemäß einer Ausführungsform;
- Figur 2: zeigt eine schematische Darstellung eines Verfahrens zum Ermitteln von Fehlerzuständen einer, einen ersten Halbleiterschalter und einen zweiten Halbleiterschalter aufweisenden Halbbrückenschaltung gemäß einer Ausführungsform.

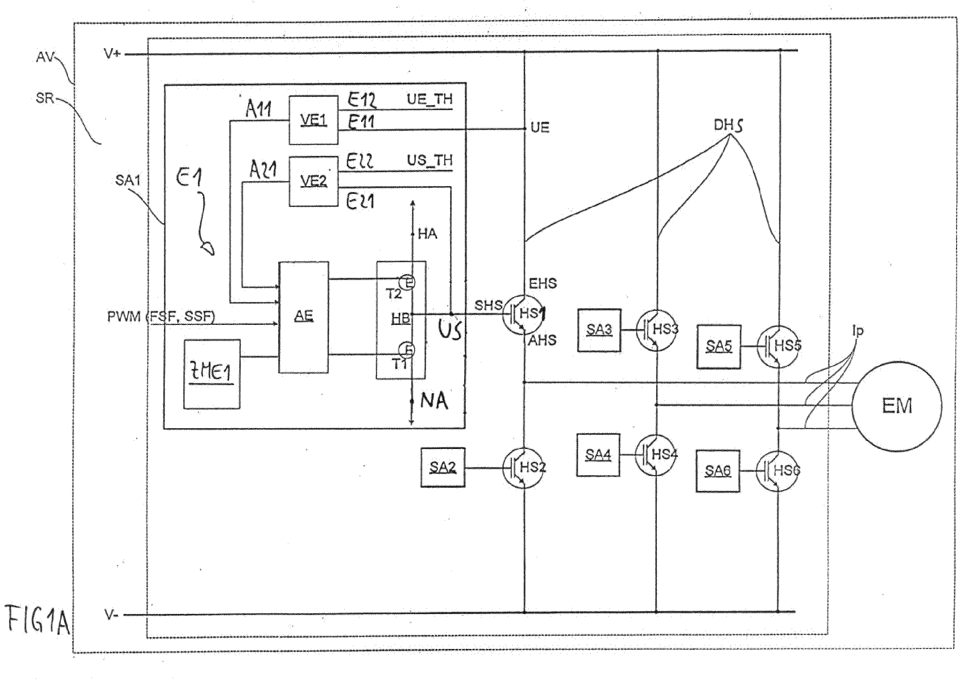

Figur 1A zeigt eine Antriebsvorrichtung AV zum Antrieb eines in Figur 1A nicht näher dargestellten Elektro- oder Hybridfahrzeugs mit einer elektrischen Maschine EM und einem Stromrichter SR in einer schematischen Darstellung gemäß einer Ausführungsform.

Die elektrische Maschine EM ist mit einer in Figur 1A nicht näher dargestellten Antriebswelle des Fahrzeugs zur Drehmomentübertragung mechanisch gekoppelt und dient zum Vortrieb des Fahrzeugs.

Der Stromrichter SR dient zum Bereitstellen von Phasenströmen Ip für die elektrische Maschine EM und weist eine Dreifach-Halbbrückenschaltung DHS mit jeweils einem hochvoltseitigen (auf Englisch "High-Side") und einem niedervoltseitigen (auf Englisch "Low-Side") Halbleiterschalter HS1 und HS2, HS3 und HS4 beziehungsweise HS5 und HS6 in einer Reihenschaltung auf. Jeder der sechs Halbleiterschalter HS1 bis HS6 weist jeweils einen Eingangsstromanschluss EHS, einen Ausgangsstromanschluss AHS und zwischen dem Eingangsstromanschluss EHS und dem Ausgangsstromanschluss AHS eine Laststrecke zum Durchleiten eines Laststromes von dem Eingangsstromanschluss EHS zu dem Ausgangsstromanschluss AHS und anschließend zu der elektrischen Maschine EM als Phasenstrom Ip auf. Ferner weisen die Halbleiterschalter HS1 bis HS6 jeweils einen Steueranschluss SHS auf, über den der jeweilige Halbleiterschalter HS1 bis HS6 angesteuert wird, um im eingeschalteten Zustand des jeweiligen Halbleiterschalters den Durchfluss des Laststroms durch die Laststrecke zu ermöglichen beziehungsweise im ausgeschalteten Zustand des jeweiligen Halbleiterschalters den Durchfluss des Laststroms durch die Laststrecke zu sperren. Die Halbleiterschalter HS1 bis HS6 sind in der gezeigten Ausführungsform n-Kanal IGBTs.

Zu jedem dieser sechs Halbleiterschalter HS1 bis HS6 weist der Stromrichter SR jeweils eine Schaltungsanordnung SA1, SA2, SA3, SA4, SA5 beziehungsweise SA6 zur Steuerung des jeweiligen Halbleiterschalters HS1 bis HS6 auf, wobei die sechs Schaltungsanordnungen SA1 bis SA6 zueinander funktional weitgehend identisch ausgebildet sind. Zur Vereinfachung der Beschreibung der Antriebsvorrichtung AV wird lediglich eine der sechs Schaltungsanordnungen SA1 bis SA6 nachfolgend detailliert beschrieben.

So wie die restlichen fünf Schaltungsanordnungen SA2 bis SA6 weist die erste Schaltungsanordnung SA1 in der gezeigten Ausführungsform eine Halbbrückenschaltungseinheit HB, eine erste Vergleichseinheit VE1, eine zweite Vergleichseinheit VE2 sowie eine Ansteuereinheit AE auf. Die Schaltungsanordnung SA1 ist mit Ausnahme von der Halbbrückenschaltungseinheit HB in einem ASIC-Bauteil ausgebildet. Dies ermöglicht eine erhebliche Reduktion der Bauteilanzahl und Bauteilkosten, benötigt weniger Leiterplattenplatz und führt zu geringeren Produktionskosten, insbesondere bei Lagerhaltung, Bestückung und Testen der Komponenten. Zudem sind zusätzliche Funktionalitäten integrierbar. Ferner sind dadurch höhere Schaltgeschwindigkeiten einstellbar, eine höhere Zuverlässigkeit sowie eine erhöhte Robustheit gegenüber EMV-Störungen werden ermöglicht und die Diagnosemöglichkeiten erweitert.

Die Halbbrückenschaltungseinheit HB weist ihrerseits je einen ersten, zwischen dem Steueranschluss SHS des Halbleiterschalters HS1 und einem ersten, negativen Versorgungsspannungsanschluss NA angeordneten, steuerbaren Treiberschalter T1 und einen zweiten, zwischen dem Steueranschluss SHS des Halbleiterschalters HS1 und einem zweiten, positiven Versorgungsspannungsanschluss HA angeordneten, steuerbaren Treiberschalter T2 in einer Reihenschaltung auf, wobei der Knotenpunkt zwischen den beiden Treiberschaltern T1 und T2, der diese beiden Treiberschalter T1 und T2 verbindet, mit dem Steueranschluss SHS des Halbleiterschalters HS1 der Dreifach-Halbbrückenschaltung DHS elektrisch verbunden ist. Dadurch wird der Halbleiterschalter HS1 der Dreifach-Halbbrückenschaltung DHS von dieser Halbbrückenschaltungseinheit HB gesteuert geschalten. Die Treiberschalter T1 und T2 sind in der gezeigten Ausführungsform Halbleiterschalter in Form von MOSFETs.

Die erste Vergleichseinheit VE1 weist einen ersten und einen zweiten Eingangsanschluss E11, E12 und einen Ausgangsanschluss A11 auf und ist über den ersten Eingangsanschluss E11 mit dem Eingangsstromanschluss EHS des Halbleiterschalters HS1 elektrisch verbunden. Über diesen ersten Eingangsanschluss E11 misst die erste Vergleichseinheit VE1 das Spannungspotential UE an dem Eingangsstromanschluss EHS des Halbleiterschalters HS1. Über den zweiten Eingangsanschluss E12 erhält die erste Vergleichseinheit VE1 ein erstes Referenzspannungspotential UE_TH von einer nicht näher dargestellten Einheit. Die erste Vergleichseinheit VE1 vergleicht das gemessene Spannungspotential UE mit dem Referenzspannungspotential UE_TH und gibt abhängig von dem Vergleichsergebnis ein Ausgangssignal an dem Ausgangsanschluss A11 aus, welches an die Ansteuereinheit AE der Schaltungsanordnung SA1 übermittelt wird.

Die zweite Vergleichseinheit VE2 weist einen ersten und einen zweiten Eingangsanschluss E21, E22 und einen Ausgangsanschluss A21 auf und ist über den ersten Eingangsanschluss E21 mit dem Steueranschluss SHS des Halbleiterschalters HS1 elektrisch verbunden. Über diesen ersten Eingangsanschluss E21 misst die zweite Vergleichseinheit VE2 das Spannungspotential US an dem Steueranschluss SHS des Halbleiterschalters HS1. Über den zweiten Eingangsanschluss E22 erhält die zweite Vergleichseinheit VE2 ein zweites Referenzspannungspotential US_TH von einer nicht näher dargestellten Einheit. Die zweite Vergleichseinheit VE2 vergleicht das gemessene Spannungspotential US mit dem Referenzspannungspotential US_TH und gibt abhängig von dem Vergleichsergebnis ein Ausgangssignal an dem Ausgangsanschluss A21 aus, welches an die Ansteuereinheit AE der Schaltungsanordnung SA1 übermittelt wird.

Die erste Vergleichseinheit VE1 und die zweite Vergleichseinheit VE2 sind typischerweise jeweils als Komparator ausgebildet.

Die Ansteuereinheit AE ist zum Ansteuern des Halbleiterschalters HS1 durch gesteuertes, beispielsweise stufenweises Ein- und Ausschalten der beiden Treiberschalter T1 und T2 unter Verwendung eines pulsweiten modulierten Steuersignals PWM, das von einer in Figur 1A nicht näher dargestellten zentralen Steuereinheit bereitgestellt wird, und insbesondere unter Verwendung von steigenden Signalflanken SSF und fallenden Signalflanken FSF des pulsweiten modulierten Steuersignals PWM ausgebildet.

Ferner ermittelt die Ansteuereinheit AE basierend auf den, von der ersten Vergleichseinheit VE1 und der zweiten Vergleichseinheit VE2 an die Ansteuereinheit AE übermittelten Ausgangssignalen den momentanen Ist-Zustand des Halbleiterschalters HS1. Damit wird durch die genannten Komponenten eine erste Ermittlungseinheit E1 zum Ermitteln des Ist-Schaltzustands des ersten Halbleiterschalters HS1 bereitgestellt.

Wie im folgenden näher erläutert wird, kann basierend auf dem Ist-Schaltzustand des ersten Halbleiterschalters HS1 und einem in entsprechender Weise ermittelten Ist-Schaltzustand des zweiten Halbleiterschalters HS2 eine Unterscheidung von Fehlerzuständen der drei Halbbrückenschaltungen der Dreifach-Halbbrückenschaltung DHS bereitgestellt werden. Hierzu weist die erste Schaltungsanordnung SA1 zudem eine erste Zeitmesseinheit ZME1 auf, welche ebenfalls im Folgenden näher erläutert wird.

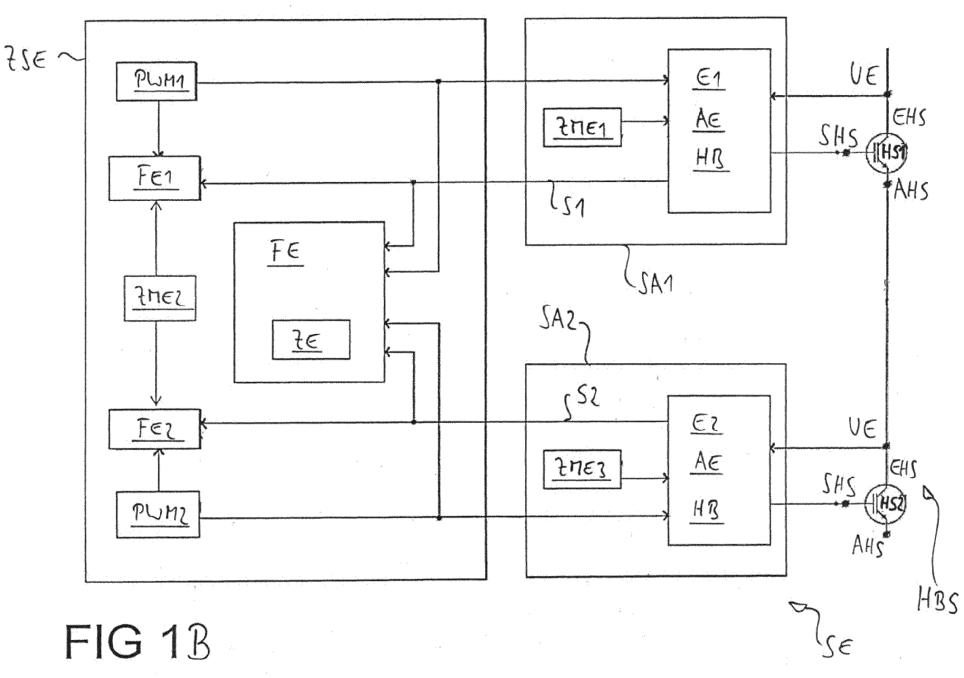

Dazu zeigt Figur 1B eine Schaltungseinheit SE zum Ermitteln von Fehlerzuständen einer Halbbrückenschaltung HBS der in Figur 1A gezeigten Dreifach-Halbbrückenschaltung gemäß einer Ausführungsform. Komponenten mit den gleichen Funktionen wie in Figur 1A werden mit den gleichen Bezugszeichen gekennzeichnet und im Folgenden nicht nochmals erläutert. Aus Gründen der Übersichtlichkeit sind in Figur 1B nicht sämtliche Komponenten der ersten Schaltungsanordnung SA1 beziehungsweise der zweiten Schaltungsanordnung SA2 dargestellt. Ferner sind die erste Ermittlungseinheit E1, die Ansteuereinheit AE und die Halbbrückentreiberschaltungseinheit HB der ersten Schaltungsanordnung SA1 in einem gemeinsamen Block zusammengefasst. Entsprechend sind eine zweite Ermittlungseinheit E2 zum Ermitteln eines Ist-Schaltzustands des zweiten Halbleiterschalters HS2, eine Ansteuereinheit AE und eine Halbbrückentreiberschaltungseinheit HB der zweiten Schaltungsanordnung SA2 in einem Block zusammengefasst.

Die Schaltungseinheit SE weist zusätzlich zu der ersten Ermittlungseinheit E1 zum Ermitteln des Ist-Schaltzustands des ersten Halbleiterschalters HS1 und der zweiten Ermittlungseinheit E2 zum Ermitteln des Ist-Schaltzustands des zweiten Halbleiterschalters HS2 eine zentrale Steuereinheit ZSE zum Ermitteln eines Soll-Schaltzustands des ersten Halbleiterschalters HS1 und eines Soll-Schaltzustands des zweiten Halbleiterschalters HS2 auf. Ferner ist die zentrale Steuereinheit ZSE zum Ansteuern des ersten Halbleiterschalters HS1 und des zweiten Halbleiterschalters HS2 mittels jeweils eines pulsweiten modulierten Steuersignals ausgebildet. Dazu weist die zentrale Steuereinheit ZSE in der gezeigten Ausführungsform einen ersten Pulsweitenmodulator PWM1 und einen zweiten Pulsweitenmodulator PWM2 auf, wobei ein von dem ersten Pulsweitenmodulator PWM1 erzeugtes Steuersignal an die Ansteuereinheit AE der ersten Schaltungsanordnung SA1 und ein von dem zweiten Pulsweitenmodulator PWM2 erzeugtes Steuersignal an die Ansteuereinheit AE der zweiten Schaltungsanordnung SA2 bereitgestellt wird.

Ferner weist die Schaltungseinheit SE eine Fehler-Ermittlungseinheit FE zum Erkennen eines Brückenkurzschlusses bei der Halbbrückenschaltung HBS auf, falls der Ist-Schaltzustand des ersten Halbleiterschalters HS1 von dem Soll-Schaltzustand des ersten Halbleiterschalters HS1 verschieden ist und zudem der Ist-Schaltzustand des zweiten Halbleiterschalters HS2 von dem Soll-Schaltzustand des zweiten Halbleiterschalters HS2 verschieden ist. Der Ist-Schaltzustand des ersten Halbleiterschalters HS1 ist dazu in der gezeigten Ausführungsform mittels eines ersten Signals über eine erste Signalleitung S1 von der ersten Schaltungsanordnung SA1 an die zentrale Steuereinheit ZSE und dabei insbesondere an die Fehler-Ermittlungseinheit FE übermittelbar. Ferner ist der Ist-Schaltzustand des zweiten Halbleiterschalters HS2 mittels eines zweiten Signals über eine zweite Signalleitung S2 von der zweiten Schaltungsanordnung SA2 an die zentrale Steuereinheit ZSE und dabei wiederum insbesondere an die Fehler-Ermittlungseinheit FE übermittelbar.

In der gezeigten Ausführungsform wird zudem die Anzahl der erkannten Brückenkurzschlüsse mittels einer Zähleinheit ZE ermittelt. Falls die ermittelte Anzahl der erkannten Brückenkurzschlüsse dabei einen vorgegebenen Schwellenwert überschreitet, werden der erste Halbleiterschalter HS1 und der zweite Halbleiterschalter HS2 in einen vorgegebenen Betriebszustand geschaltet. In der gezeigten Ausführungsform werden der erste Halbleiterschalter HS1 und der zweite Halbleiterschalter HS2 und damit die Halbbrückenschaltung HBS in diesem Fall dauerhaft ausgeschaltet.

Die Fehler-Ermittlungseinheit FE ist ferner zum Erkennen eines Einzelfehlers des ersten Halbleiterschalters HS1 ausgebildet, falls der Ist-Schaltzustand des ersten Halbleiterschalters HS1 von dem Soll-Schaltzustand des ersten Halbleiterschalters HS1 verschieden ist und zudem der Ist-Schaltzustand des zweiten Halbleiterschalters HS2 dem Soll-Schaltzustand des zweiten Halbleiterschalters HS2 entspricht. Ferner ist die Fehler-Ermittlungseinheit FE zum Erkennen eines Einzelfehlers des zweiten Halbleiterschalters HS2 ausgebildet, falls der Ist-Schaltzustand des zweiten Halbleiterschalters HS2 von dem Soll-Schaltzustand des zweiten Halbleiterschalters HS2 verschieden ist und zudem der Ist-Schaltzustand des ersten Halbleiterschalters HS1 dem Soll-Schaltzustand des ersten Halbleiterschalters HS1 entspricht. Die Ist-Schaltzustände der beiden Halbleiterschalter HS1 und HS2 werden dabei wiederum über die erste Signalleitung S1 beziehungsweise die zweite Signalleitung S2 an die Fehler-Ermittlungseinheit FE übermittelt.

Die Schaltungseinheit SE weist ferner eine erste Zeitmesseinheit ZME1 zum Starten einer ersten Zeitmessung nach einem Empfangen einer Schalt-Anforderung der zentralen Steuereinheit ZSE durch die erste Schaltungsanordnung SA1 für ein Schalten des ersten Halbleiterschalters HS1 in den geschlossenen Schaltzustand auf, falls der erste Halbleiterschalter HS1 momentan geöffnet ist. Ferner weist die Schaltungseinheit SE eine dritte Zeitmesseinheit ZME3 zum Starten einer dritten Zeitmessung nach einem Empfangen einer Schalt-Anforderung der zentralen Steuereinheit ZSE durch die zweite Schaltungsanordnung SA2 für ein Schalten des zweiten Halbleiterschalters HS2 in den geschlossenen Schaltzustand auf, falls der zweite Halbleiterschalter HS2 momentan geöffnet ist. Darüber hinaus weist die Schaltungseinheit SE eine zweite Zeitmesseinheit ZME2 auf zum Starten einer zweiten Zeitmessung, sobald eine Schalt-Anforderung der zentralen Steuereinheit ZSE für ein Schalten des ersten Halbleiterschalters HS1 oder des zweiten Halbleiterschalters HS2 in den geschlossenen Schaltzustand erfolgt ist. Die erste Zeitmesseinheit ZME1 ist dabei Bestandteil der ersten Schaltungsanordnung SA1, die dritte Zeitmesseinheit ZME3 Bestandteil der zweiten Schaltungsanordnung SA2 und die zweite Zeitmesseinheit ZME2 Bestandteil der zentralen Steuereinheit ZSE. Die erste Zeitmesseinheit ZME1, die zweite Zeitmesseinheit ZME2 und die dritte Zeitmesseinheit ZME3 sind beispielsweise jeweils in Form eines Taktgenerators beziehungsweise Oszillators ausgebildet. Insbesondere können die genannten Zeitmessungen derart erfolgen, dass eine Anzahl von Pulsen mit vorgegebener Pulsdauer bestimmt wird.

Der Ist-Schaltzustand des ersten Halbleiterschalters HS1 wird dabei nach einer vorbestimmten Dauer nach dem Start der ersten Zeitmessung mittels des ersten Signals über die erste Signalleitung S1 von der ersten Schaltungsanordnung SA1 an die zentrale Steuereinheit ZSE übermittelt. Entsprechend wird der Ist-Schaltzustand des zweiten Halbleiterschalters HS2 nach einer vorbestimmten Dauer nach dem Start der dritten Zeitmessung mittels des zweiten Signals über die zweite Signalleitung S2 von der zweiten Schaltungsanordnung SA2 an die zentrale Steuereinheit ZSE übermittelt.

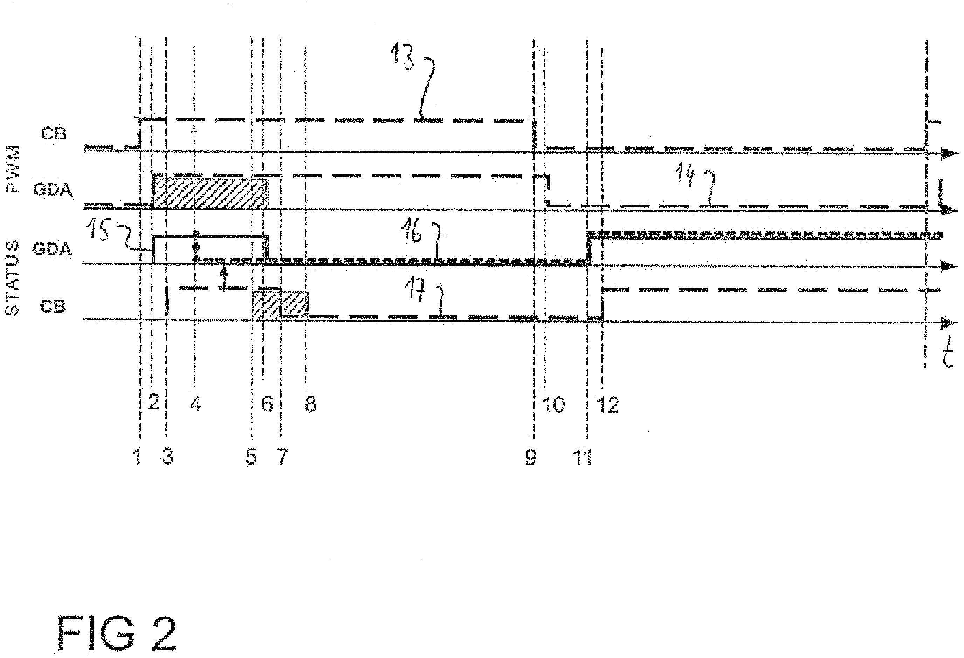

Die zentrale Steuereinheit ZSE ist zum Erkennen eines Fehlerzustands ausgebildet, falls der an die zentrale Steuereinheit ZSE übermittelte Ist-Schaltzustand des ersten Halbleiterschalters HS1 oder des zweiten Halbleiterschalters HS2 nicht innerhalb eines vorbestimmten Zeitintervalls nach dem Start der zweiten Zeitmessung von dem geöffneten Schaltzustand in den geschlossenen Schaltzustand wechselt. Insbesondere kann dabei von der zentralen Steuereinheit ZSE ein Fehlerzustand der ersten Zeitmesseinheit ZME1 beziehungsweise der dritten Zeitmesseinheit ZME3 erkannt werden, falls der an die zentrale Steuereinheit ZSE übermittelte Ist-Schaltzustand vor Beginn des vorbestimmten Zeitintervalls nach dem Start der zweiten Zeitmessung von dem geöffneten Schaltzustand in den geschlossenen Schaltzustand wechselt, wie im Zusammenhang mit Figur 2 näher erläutert wird.

Die zentrale Steuereinheit ZSE weist dazu in der gezeigten Ausführungsform eine erste Fehler-Ermittlungseinheit FE1 und eine zweite Fehler-Ermittlungseinheit FE2 auf. Dabei wird der Ist-Schaltzustand des ersten Halbleiterschalters HS1 über die erste Signalleitung S1 von der ersten Schaltungsanordnung SA1 an die erste Fehler-Ermittlungseinheit FE1 übermittelt. Ferner wird das von dem ersten Pulsweitenmodulator PWM1 erzeugte Steuersignal an die erste Fehler-Ermittlungseinheit FE1 übermittelt. Entsprechend wird der Ist-Schaltzustand des zweiten Halbleiterschalters HS2 über die zweite Signalleitung S2 von der zweiten Schaltungsanordnung SA2 an die zweite Fehler-Ermittlungseinheit FE2 übermittelt und dieser zudem das von dem zweiten Pulsweitenmodulator PWM2 erzeugte Steuersignal bereitgestellt. Darüber hinaus werden der ersten Fehler-Ermittlungseinheit FE1 und der zweiten Fehler-Ermittlungseinheit FE2 die von der zweiten Zeitmesseinheit ZME2 gemessene Zeitdauer bereitgestellt. Weitere Einzelheiten werden im Zusammenhang mit Figur 2 näher erläutert.

Mittels der gezeigten Ausführungsform können somit mit einem einzigen Signal für den jeweiligen Halbleiterschalter ein Fehlerzustand der jeweiligen Zeitmesseinheit, beispielsweise in Form einer Oszillatordrift, ein Statusfehler des jeweiligen Halbleiterschalters, beispielsweise ein Abschalten des Halbleiterschalters auf Grund einer erkannten Unterspannung, und ein Brückenkurzschluss voneinander unterschieden werden.

Figur 2 zeigt eine schematische Darstellung eines Verfahrens zum Ermitteln von Fehlerzuständen einer, einen ersten Halbleiterschalter und einen zweiten Halbleiterschalter aufweisenden Halbbrückenschaltung gemäß einer Ausführungsform.

In Figur 2 ist der zeitliche Verlauf des von der zentralen Steuereinheit, welche in Figur 2 als CB (Steuerkreis, auf Englisch "Control Board") bezeichnet wird, bereitgestellten pulsweiten modulierten Steuersignals schematisch durch ein Signal 13 dargestellt. Das von der Schaltungsanordnung des zu schaltenden Halbleiterschalters empfangene pulsweiten modulierte Steuersignal ist schematisch mittels eines Signals 14 dargestellt. Die Schaltungsanordnung wird dabei in Figur 2 als GDA (Gate-Treiber A, auf Englisch "Gate Driver A") bezeichnet, wobei A für den jeweiligen zu schaltenden Halbleiterschalter steht.

Das von der Schaltungsanordnung an die zentrale Steuereinheit übermittelte, den Ist-Schaltzustand des jeweiligen Halbleiterschalters kennzeichnende Signal ist schematisch mittels eines Signals 15 dargestellt. Ferner ist das von der zentralen Steuereinheit empfangene, den Ist-Schaltzustand kennzeichnende Signal schematisch mittels eines Signals 17 dargestellt.

Zu einem ersten Zeitpunkt 1 sendet die zentrale Steuereinheit eine Schalt-Anforderung für ein Schalten eines momentan geöffneten Halbleiterschalters des ersten und zweiten Halbleiterschalters in den geschlossenen Schaltzustand an die Schaltungsanordnung des zu schaltenden Halbleiterschalters. Die zentrale Steuereinheit kommandiert somit über die PWM-Leitung ein Einschalten des entsprechenden Halbleiterschalters. Zudem wird zu diesem ersten Zeitpunkt 1 eine zweite Zeitmessung einer Zeitmesseinheit der zentralen Steuereinheit gestartet.

Zu einem zweiten, späteren Zeitpunkt 2 empfängt die Schaltungsanordnung des zu schaltenden Halbleiterschalters den Einschaltbefehl. Die Schaltungsanordnung empfängt dabei den Einschaltbefehl auf Grund von Laufzeitverzögerungen verspätet. Die Schaltungsanordnung startet zu diesem zweiten Zeitpunkt 2 eine erste Zeitmessung einer Zeitmesseinheit der Schaltungsanordnung. Die Zeitmesseinheit der Schaltungsanordnung ist dabei unabhängig von der Zeitmesseinheit der zentralen Steuereinheit.

Nach dem Empfangen des Einschaltbefehls manipuliert die Schaltungsanordnung das an die zentrale Steuereinheit zu übermittelnde Status-Signal des Halbleiterschalters, das heißt das, den Ist-Schaltzustand des Halbleiterschalters kennzeichnende Signal derart, dass dieses weiterhin einen ausgeschalteten Zustand des Halbleiterschalters kennzeichnet. In der gezeigten Ausführungsform wird dazu von der Schaltungsanordnung zwischen dem zweiten Zeitpunkt 2 und einem sechsten Zeitpunkt 6 das Signal 15 mit einem hohen Pegel an die zentrale Steuereinheit übermittelt. Diese empfängt das Signal mit hohem Pegel wiederum auf Grund von Laufzeitverzögerungen verzögert zu einem dritten Zeitpunkt 3.

Zu einem vierten, späteren Zeitpunkt 4 erkennt die Schaltungsanordnung intern auf Grund einer fallenden Signalflanke bei dem von der ersten Vergleichseinheit übermittelten und in Figur 2 mittels eines Signals 16 dargestellten Ausgangssignal, dass der Halbleiterschalter von dem geöffneten Schaltzustand in den geschlossenen Schaltzustand übergegangen ist.

Die ermittelte Änderung des Ist-Schaltzustands von dem geöffneten Schaltzustand in den geschlossenen Schaltzustand wird jedoch erst nach einer vorbestimmten Dauer nach dem Start der ersten Zeitmessung an die zentrale Steuereinheit übermittelt. In der gezeigten Ausführungsform erfolgt dies, wie bereits erläutert, zu dem sechsten Zeitpunkt 6. Damit entspricht das an die zentrale Steuereinheit übermittelte, den Ist-Schaltzustand des Halbleiterschalters kennzeichnende Signal bis zu diesem sechsten Zeitpunkt 6 nicht mehr dem tatsächlichen, von der Schaltungsanordnung ermittelten Ist-Schaltzustand des Halbleiterschalters.

Ab dem sechsten Zeitpunkt 6 ist das von der Schaltungsanordnung an die zentrale Steuereinheit übermittelte Signal wieder identisch mit dem tatsächlichen Ist-Schaltzustand des Halbleiterschalters.

Die zentrale Steuereinheit empfängt die übermittelte, einen Wechsel von dem geöffneten Schaltzustand in den geschlossenen Schaltzustand kennzeichnende Signaländerung wiederum zeitverzögert zu einem siebten, späteren Zeitpunkt 7.

Bei einem fehlerfreien Betrieb des zu schaltenden Halbleiterschalters erwartet die zentrale Steuereinheit die den Wechsel von dem geöffneten Schaltzustand in den geschlossenen Schaltzustand kennzeichnende Signaländerung bei dem übermittelten Signal, beispielsweise in Form einer fallenden Signalflanke, innerhalb eines vorbestimmten Zeitintervalls nach dem Start der zweiten Zeitmessung, d.h. in der gezeigten Ausführungsform in einem Bereich zwischen einem fünften Zeitpunkt 5 und einem achten Zeitpunkt 8.

In der gezeigten Darstellung befindet sich der siebte Zeitpunkt 7 in dem vorbestimmten Zeitintervall zwischen dem fünften Zeitpunkt 5 und dem achten Zeitpunkt 8. Somit wird von der zentralen Steuereinheit ein fehlerfreier Betrieb des zu schaltenden Halbleiterschalters erkannt.

Falls hingegen der an die zentrale Steuereinheit übermittelte Ist-Schaltzustand nicht innerhalb des vorbestimmten Zeitintervalls nach dem Start der zweiten Zeitmessung von dem geöffneten Schaltzustand in den geschlossenen Schaltzustand wechselt, wird von der zentralen Steuereinheit ein Fehlerzustand erkannt. Insbesondere wird dabei ein Fehlerzustand der Zeitmesseinheit der Schaltungsanordnung erkannt, falls der an die zentrale Steuereinheit übermittelte Ist-Schaltzustand vor Beginn des vorbestimmten Zeitintervalls von dem geöffneten Schaltzustand in den geschlossenen Schaltzustand wechselt. In diesem Fall erfolgt die erste Zeitmessung zu schnell.

Falls der an die zentrale Steuereinheit übermittelte Ist-Schaltzustand nach Ende des vorbestimmten Zeitintervalls von dem geöffneten Schaltzustand in den geschlossenen Schaltzustand wechselt, wird ebenfalls ein Fehlerzustand von der zentralen Steuereinheit erkannt, wobei in diesem Fall sowohl ein Fehlerzustand der Zeitmesseinheit der Schaltungsanordnung in Form einer zu langsamen Zeitmessung als auch ein interner Statusfehler des zu schaltenden Halbleiterschalters vorliegen können.

Bei einem von der zentralen Steuereinheit erkannten Fehlerzustand leitet diese jeweils die aus Systemsicht sichere Reaktion ein.

Zu einem neunten, späteren Zeitpunkt 9 übermittelt die zentrale Steuereinheit eine Schalt-Anforderung für ein Schalten des momentan geschlossenen Halbleiterschalters in den geöffneten Schaltzustand an die Schaltungsanordnung des Halbleiterschalters. Diese empfängt den Abschaltbefehl auf Grund der Laufzeitverzögerungen zu einem zehnten, späteren Zeitpunkt 10 verzögert. Zu einem elften Zeitpunkt 11 wechselt das, den Ist-Schaltzustand des Halbleiterschalters kennzeichnende Signal von dem geschlossenen Schaltzustand in den geöffneten Schaltzustand. Dies erfolgt in der gezeigten Darstellung in Form einer steigenden Signalflanke, das heißt eines Wechsels von einem niedrigen zu einem hohen Signalpegel bei dem von der ersten Vergleichseinheit ausgegebenen Ausgangssignal. Die zentrale Steuereinheit empfängt diese Statusänderung wiederum auf Grund der Laufzeitverzögerungen zu einem zwölften, späteren Zeitpunkt 12 verzögert.

Für das GDA stellt ein Abschalten des Halbleiterschalters dabei für jeden erkannten Fehler den sicheren Zustand dar. Das CB erkennt den Fehler dadurch, dass bei anliegendem PWM-Einschaltbefehl die fallende Flanke bis zu dem achten Zeitpunkt 8 nicht erfolgt oder der Status zwischen dem achten Zeitpunkt 8 und dem neunten Zeitpunkt 9 wieder auf den hohen Signalpegel wechselt (für den Fall, dass der Fehler erst während der leitenden Periode auftritt). Die spezielle Erkennung eines Brückenkurzschlusses wird von dem CB durch Auswertung und Vergleich beider Status-Signale der Halbbrücke ermöglicht. Während bei jedem anderen Fehler dieser nur über ein Status-Signal angezeigt wird, wird der Brückenkurzschlusses sowohl bei dem Status-Signal des ersten und des zweiten Halbleiterschalters gemeldet.

Sollte beispielsweise der erste Halbleiterschalter eingeschaltet sein und der zweite Halbleiterschalter während anliegendem PWM-Ausschaltbefehl durchlegieren, so liegt ein Brückenkurzschluss vor. Der erste Halbleiterschalter kann den dann auftretenden Strom nicht mehr führen, entsättigt und wird von dem GDA abgeschaltet. Sein Status meldet diesen Fehler durch Wechsel auf den hohen Signalpegel. In unmittelbarer zeitlicher Nähe dazu wird der Status des zweiten Halbleiterschaltern einen niedrigen Signalpegel, d.h. leitend, melden, obwohl dieser eigentlich abgeschaltet sein sollte. Beim Durchlegieren des ersten Halbleiterschalters gilt entsprechendes.

Im der folgenden Tabelle sind die unterschiedlichen Fälle jeweils für den hochvoltseitigen und niedervoltseitigen Schalter einer Halbbrücke dargestellt. Dabei kennzeichnet PWM_HS den Soll-Schaltzustand des ersten Halbleiterschalters, STATUS_HS den Ist-Schaltzustand des ersten Halbleiterschalters, PWM_LS den Soll-Schaltzustand des zweiten Halbleiterschalters und STATUS_LS den Ist-Schaltzustand des zweiten Halbleiterschalters.

| | | | | | | | | |
|---|---|---|---|---|---|---|---|---|
| PWM_HS | Ein | Ein | Ein | Ein | Aus | Aus | Aus | Aus |
| STATUS_HS | Ein | Aus | Aus | Ein | Aus | Aus | Ein | Ein |
| PWM_LS | Aus | Aus | Aus | Aus | Ein | Ein | Ein | Ein |
| STATUS_LS | Aus | Aus | Ein | Ein | Ein | Aus | Aus | Ein |
| Fehlerfall | 0 | 1 | 2 | 3 | 0 | 1 | 2 | 3 |

Fehlerfall 0 kennzeichnet einen fehlerfreien Betrieb, d.h. HS-und LS-Status melden den erwarteten Wert zurück. Bei Fehlerfall 1 meldet lediglich der Schalter mit Einschaltbefehl einen falschen Status, d.h. einen Fehler, zurück, der ausgeschaltete Schalter besitzt hingegen den erwarteten Wert. Daraus kann auf einen Fehler der Schaltungsanordnung des Halbleiterschalters mit Einschaltbefehl geschlossen werden, z.B. eine Unterspannung. Bei Fehlerfall 2 melden beide Status-Signale einen Fehler. Der abgeschaltete Schalter ist durchlegiert, der weitere Schalter kann den hohen Kurzschlussstrom nicht dauerhaft führen und schaltet dann ab. Fehlerfall 2 kennzeichnet somit einen Brückenkurzschluss, d.h. der Kurzschlusszähler wird inkrementiert. Fehlerfall 3 kennzeichnet eine defekte Statusrückleitung des ausgeschalteten Schalters, d.h. dieser scheint dauerhaft "Ein" zu melden. In diesem Fall erfolgt zunächst keine Reaktion.

## Patentansprüche

1. Verfahren zum Ermitteln von Fehlerzuständen einer, einen ersten Halbleiterschalter (HS1) und einen zweiten Halbleiterschalter (HS2) aufweisenden Halbbrückenschaltung (HBS), wobei der erste Halbleiterschalter (HS1) und der zweite Halbleiterschalter (HS2) zueinander in einer Reihenschaltung geschaltet und mittels jeweils eines Steuersignals steuerbar sind und wobei der erste Halbleiterschalter (HS1) und der zweite Halbleiterschalter (HS2) jeweils einen geöffneten und einen geschlossenen Schaltzustand einnehmen können und wobei das Verfahren folgende Verfahrensschritte aufweist:
- Ermitteln eines Ist-Schaltzustands und eines Soll-Schaltzustands des ersten Halbleiterschalters (HS1),
- Ermitteln eines Ist-Schaltzustands und eines Soll-Schaltzustands des zweiten Halbleiterschalters (HS2),
- Erkennen eines Brückenkurzschlusses bei der Halbbrückenschaltung (HBS), falls der Ist-Schaltzustand des ersten Halbleiterschalters (HS1) von dem Soll-Schaltzustand des ersten Halbleiterschalters (HS1) verschieden ist und zudem der Ist-Schaltzustand des zweiten Halbleiterschalters (HS2) von dem Soll-Schaltzustand des zweiten Halbleiterschalters (HS2) verschieden ist.

2. Verfahren nach Anspruch 1, wobei der Soll-Schaltzustand eines Halbleiterschalters des ersten und zweiten Halbleiterschalters (HS1, HS2) geschlossen ist und wobei der Soll-Schaltzustand des weiteren Halbleiterschalters des ersten und zweiten Halbleiterschalters (HS1, HS2) geöffnet ist und wobei ein Brückenkurzschluss bei der Halbbrückenschaltung erkannt wird, falls der Ist-Schaltzustand des in dem Soll-Schaltzustand geschlossenen Halbleiterschalters geöffnet ist und zudem der Ist-Schaltzustand des in dem Soll-Schaltzustand geöffneten Halbleiterschalters geschlossen ist.

3. Verfahren nach Anspruch 1 oder Anspruch 2, wobei zudem eine Anzahl der erkannten Brückenkurzschlüsse ermittelt wird und wobei, falls die ermittelte Anzahl der erkannten Brückenkurzschlüsse einen vorgegebenen Schwellenwert überschreitet, der erste Halbleiterschalter (HS1) und der zweite Halbleiterschalter (HS2) in einen vorgegebenen Betriebszustand geschaltet werden.

4. Verfahren nach einem der vorhergehenden Ansprüche, wobei der erste Halbleiterschalter (HS1) mittels einer ersten Schaltungsanordnung (SA1) ansteuerbar ist und wobei der zweite Halbleiterschalter (HS2) mittels einer zweiten Schaltungsanordnung (SA2) ansteuerbar ist und wobei das Ermitteln des Ist-Schaltzustands des ersten Halbleiterschalters (HS1) mittels der ersten Schaltungsanordnung (SA1) und das Ermitteln des Ist-Schaltzustands des zweiten Halbleiterschalters (HS2) mittels der zweiten Schaltungsanordnung (SA2) erfolgt.

5. Verfahren nach Anspruch 4, wobei der Ist-Schaltzustand des ersten Halbleiterschalters (HS1) mittels eines ersten Signals über eine erste Signalleitung (S1) von der ersten Schaltungsanordnung (SA1) an eine zentrale Steuereinheit (ZSE) der Halbbrückenschaltung (HBS) übermittelt wird und der Ist-Schaltzustand des zweiten Halbleiterschalters (HS2) mittels eines zweiten Signals über eine zweite Signalleitung (S2) von der zweiten Schaltungsanordnung (SA2) an die zentrale Steuereinheit (ZSE) übermittelt wird und wobei das Erkennen des Brückenkurzschlusses mittels der zentralen Steuereinheit (ZSE) basierend auf dem übermittelten ersten und zweiten Signal erfolgt.

6. Verfahren nach Anspruch 5, wobei mittels der zentralen Steuereinheit (ZSE) zudem ein Fehlerzustand des ersten Halbleiterschalters (HS1) erkannt wird, falls der Ist-Schaltzustand des ersten Halbleiterschalters (HS1) von dem Soll-Schaltzustand des ersten Halbleiterschalters (HS1) verschieden ist und zudem der Ist-Schaltzustand des zweiten Halbleiterschalters (HS2) dem Soll-Schaltzustand des zweiten Halbleiterschalters (HS2) entspricht und wobei mittels der zentralen Steuereinheit (ZSE) zudem ein Fehlerzustand des zweiten Halbleiterschalters (HS2) erkannt wird, falls der Ist-Schaltzustand des zweiten Halbleiterschalters (HS2) von dem Soll-Schaltzustand des zweiten Halbleiterschalters (HS2) verschieden ist und zudem der Ist-Schaltzustand des ersten Halbleiterschalters (HS1) dem Soll-Schaltzustand des ersten Halbleiterschalters (HS1) entspricht.

7. Verfahren nach Anspruch 5 oder Anspruch 6, wobei zudem eine Schalt-Anforderung der zentralen Steuereinheit (ZSE) für ein Schalten eines momentan geöffneten Halbleiterschalters des ersten und zweiten Halbleiterschalters (HS1, HS2) in den geschlossenen Schaltzustand an die Schaltungsanordnung (SA1, SA2) des zu schaltenden Halbleiterschalters (HS1, HS2) gesendet wird und wobei nach dem Empfangen der Schalt-Anforderung durch die Schaltungsanordnung (SA1, SA2) des zu schaltenden Halbleiterschalters (HS1, HS2) eine erste Zeitmessung einer Zeitmesseinheit (ZME1, ZME3) der Schaltungsanordnung (SA1, SA2) gestartet wird und wobei der Ist-Schaltzustand des zu schaltenden Halbleiterschalters (HS1, HS2) nach dem Start der ersten Zeitmessung ermittelt wird und wobei der ermittelte Ist-Schaltzustand nach einer vorbestimmten Dauer nach dem Start der ersten Zeitmessung über die Signalleitung des zu schaltenden Halbleiterschalters (HS1, HS2) an die zentrale Steuereinheit (ZSE) übermittelt wird.

8. Verfahren nach Anspruch 7, wobei zudem eine zweite Zeitmessung einer zweiten Zeitmesseinheit (ZME2) der zentralen Steuereinheit (ZSE) gestartet wird, sobald die Schalt-Anforderung der zentralen Steuereinheit (ZSE) erfolgt ist und wobei ermittelt wird, ob der an die zentrale Steuereinheit (ZSE) übermittelte Ist-Schaltzustand innerhalb eines vorbestimmten Zeitintervalls nach dem Start der zweiten Zeitmessung von dem geöffneten Schaltzustand in den geschlossenen Schaltzustand wechselt.

9. Verfahren nach Anspruch 8, wobei von der zentralen Steuereinheit (ZSE) ein Fehlerzustand erkannt wird, falls der an die zentrale Steuereinheit (ZSE) übermittelte Ist-Schaltzustand nicht innerhalb des vorbestimmten Zeitintervalls nach dem Start der zweiten Zeitmessung von dem geöffneten Schaltzustand in den geschlossenen Schaltzustand wechselt.

10. Verfahren nach Anspruch 8 oder Anspruch 9, wobei von der zentralen Steuereinheit (ZSE) ein Fehlerzustand der Zeitmesseinheit (ZME1, ZME3) der Schaltungsanordnung (SA1, SA2) erkannt wird, falls der an die zentrale Steuereinheit (ZSE) übermittelte Ist-Schaltzustand vor Beginn des vorbestimmten Zeitintervalls nach dem Start der zweiten Zeitmessung von dem geöffneten Schaltzustand in den geschlossenen Schaltzustand wechselt.

11. Schaltungseinheit zum Ermitteln von Fehlerzuständen einer, einen ersten Halbleiterschalter (HS1) und einen zweiten Halbleiterschalter (HS2) aufweisenden Halbbrückenschaltung (HBS), wobei der erste Halbleiterschalter (HS1) und der zweite Halbleiterschalter (HS2) zueinander in einer Reihenschaltung geschaltet sind und wobei der erste Halbleiterschalter (HS1) und der zweite Halbleiterschalter (HS2) jeweils einen geöffneten und einen geschlossenen Schaltzustand einnehmen können, aufweisend:
- eine erste Ermittlungseinheit (E1) zum Ermitteln eines Ist-Schaltzustands des ersten Halbleiterschalters (HS1),
- eine zweite Ermittlungseinheit (E2) zum Ermitteln eines Ist-Schaltzustands des zweiten Halbleiterschalters (HS2),
- eine zentrale Steuereinheit (ZSE) zum Ermitteln eines Soll-Schaltzustands des ersten Halbleiterschalters (HS1) und eines Soll-Schaltzustands des zweiten Halbleiterschalters (HS2) und zum Ansteuern des ersten Halbleiterschalters (HS1) und des zweiten Halbleiterschalters (HS2) mittels jeweils eines Steuersignals,
- eine Fehler-Ermittlungseinheit (FE) zum Erkennen eines Brückenkurzschlusses bei der Halbbrückenschaltung (HBS), falls der Ist-Schaltzustand des ersten Halbleiterschalters (HS1) von dem Soll-Schaltzustand des ersten Halbleiterschalters (HS1) verschieden ist und zudem der Ist-Schaltzustand des zweiten Halbleiterschalters (HS2) von dem Soll-Schaltzustand des zweiten Halbleiterschalters (HS2) verschieden ist.

12. Schaltungseinheit nach Anspruch 11, weiterhin aufweisend:
- eine erste Schaltungsanordnung (SA1) zum Ansteuern des ersten Halbleiterschalters (HS1), wobei die erste Schaltungsanordnung (SA1) die erste Ermittlungseinheit (E1) aufweist,
- eine zweite Schaltungsanordnung (SA2) zum Ansteuern des zweiten Halbleiterschalters (HS2), wobei die zweite Schaltungsanordnung (SA2) die zweite Ermittlungseinheit (E2) aufweist,
wobei der Ist-Schaltzustand des ersten Halbleiterschalters (HS1) mittels eines ersten Signals über eine erste Signalleitung (S1) von der ersten Schaltungsanordnung (SA1) an die zentrale Steuereinheit (ZSE) übermittelbar ist und der Ist-Schaltzustand des zweiten Halbleiterschalters (HS2) mittels eines zweiten Signals über eine zweite Signalleitung (S2) von der zweiten Schaltungsanordnung (SA2) an die zentrale Steuereinheit (ZSE) übermittelbar ist und wobei die zentrale Steuereinheit (ZSE) die Fehler-Ermittlungseinheit (FE) aufweist und zum Erkennen des Brückenkurzschlusses basierend auf dem ersten und zweiten Signal ausgebildet ist.

13. Schaltungseinheit nach Anspruch 12, wobei die zentrale Steuereinheit (ZSE) zum Erkennen eines Fehlerzustands des ersten Halbleiterschalters (HS1) ausgebildet ist, falls der Ist-Schaltzustand des ersten Halbleiterschalters (HS1) von dem Soll-Schaltzustand des ersten Halbleiterschalters (HS1) verschieden ist und zudem der Ist-Schaltzustand des zweiten Halbleiterschalters (HS2) dem Soll-Schaltzustand des zweiten Halbleiterschalters (HS2) entspricht und wobei die zentrale Steuereinheit (ZSE) zum Erkennen eines Fehlerzustands des zweiten Halbleiterschalters (HS2) ausgebildet ist, falls der Ist-Schaltzustand des zweiten Halbleiterschalters (HS2) von dem Soll-Schaltzustand des zweiten Halbleiterschalters (HS2) verschieden ist und zudem der Ist-Schaltzustand des ersten Halbleiterschalters (HS1) dem Soll-Schaltzustand des ersten Halbleiterschalters (HS1) entspricht.

14. Schaltungseinheit nach Anspruch 12 oder Anspruch 13, weiterhin aufweisend:
- eine erste Zeitmesseinheit (ZME1) zum Starten einer ersten Zeitmessung nach einem Empfangen einer Schalt-Anforderung der zentralen Steuereinheit (ZSE) durch die erste Schaltungsanordnung (SA1) für ein Schalten des ersten Halbleiterschalters (HS1) in den geschlossenen Schaltzustand,
- eine zweite Zeitmesseinheit (ZME2) zum Starten einer zweiten Zeitmessung, sobald eine Schalt-Anforderung der zentralen Steuereinheit (ZSE) für ein Schalten des ersten Halbleiterschalters (HS1) oder des zweiten Halbleiterschalters (HS2) in den geschlossenen Schaltzustand erfolgt ist,
- eine dritte Zeitmesseinheit (ZME3) zum Starten einer dritten Zeitmessung nach einem Empfangen einer Schalt-Anforderung der zentralen Steuereinheit (ZSE) durch die zweite Schaltungsanordnung (SA2) für ein Schalten des zweiten Halbleiterschalters (HS2) in den geschlossenen Schaltzustand,
wobei der Ist-Schaltzustand des ersten Halbleiterschalters (HS1) nach einer vorbestimmten Dauer nach dem Start der ersten Zeitmessung mittels des ersten Signals über die erste Signalleitung (S1) von der ersten Schaltungsanordnung (SA1) an die zentrale Steuereinheit (ZSE) übermittelbar ist und wobei der Ist-Schaltzustand des zweiten Halbleiterschalters (HS2) nach einer vorbestimmten Dauer nach dem Start der dritten Zeitmessung mittels des zweiten Signals über die zweite Signalleitung (S2) von der zweiten Schaltungsanordnung (SA2) an die zentrale Steuereinheit (ZSE) übermittelbar ist.

15. Schaltungseinheit nach Anspruch 14, wobei die zentrale Steuereinheit (ZSE) zum Erkennen eines Fehlerzustands ausgebildet ist, falls der an die zentrale Steuereinheit (ZSE) übermittelte Ist-Schaltzustand des ersten Halbleiterschalters (HS1) oder des zweiten Halbleiterschalters (HS2) nicht innerhalb eines vorbestimmten Zeitintervalls nach dem Start der zweiten Zeitmessung von dem geöffneten Schaltzustand in den geschlossenen Schaltzustand wechselt.

## Claims

1. Method for determining fault states in a half-bridge circuit (HBS) having a first semiconductor switch (HS1) and a second semiconductor switch (HS2), wherein the first semiconductor switch (HS1) and the second semiconductor switch (HS2) are connected to one another in a series circuit and are controllable in each case by means of a control signal, and wherein the first semiconductor switch (HS1) and the second semiconductor switch (HS2) can in each case assume an open and a closed switching state, and wherein the method has the following method steps:
- determining an actual switching state and a reference switching state of the first semiconductor switch (HS1),
- determining an actual switching state and a reference switching state of the second semiconductor switch (HS2),
- detecting a bridge short circuit in the half-bridge circuit (HBS) if the actual switching state of the first semiconductor switch (HS1) is different from the reference switching state of the first semiconductor switch (HS1) and moreover the actual switching state of the second semiconductor switch (HS2) is different from the reference switching state of the second semiconductor switch (HS2).

2. Method according to Claim 1, wherein the reference switching state of a semiconductor switch of the first and second semiconductor switches (HS1, HS2) is closed, and wherein the reference switching state of the further semiconductor switch of the first and second semiconductor switches (HS1, HS2) is open, and wherein a bridge short circuit in the half-bridge circuit is detected if the actual switching state of the semiconductor switch that is closed in the reference switching state is open and furthermore the actual switching state of the semiconductor switch that is open in the reference switching state is closed.

3. Method according to Claim 1 or Claim 2, wherein a number of detected bridge short circuits is furthermore determined, and wherein, if the determined number of detected bridge short circuits exceeds a predefined threshold value, the first semiconductor switch (HS1) and the second semiconductor switch (HS2) are switched to a predefined operating state.

4. Method according to one of the preceding claims, wherein the first semiconductor switch (HS1) is controllable by means of a first circuit arrangement (SA1) and wherein the second semiconductor switch (HS1) is controllable by means of a second circuit arrangement (SA2), and wherein the actual switching state of the first semiconductor switch (HS1) is determined by means of the first circuit arrangement (SA1) and the actual switching state of the second semiconductor switch (HS2) is determined by means of the second circuit arrangement (SA2).

5. Method according to Claim 4, wherein the actual switching state of the first semiconductor switch (HS1) is transmitted by means of a first signal via a first signal line (S1) from the first circuit arrangement (SA1) to a central control unit (ZSE) of the half-bridge circuit (HBS) and the actual switching state of the second semiconductor switch (HS2) is transmitted by means of a second signal via a second signal line (S2) from the second circuit arrangement (SA2) to the central control unit (ZSE), and wherein the bridge short circuit is detected by means of the central control unit (ZSE) on the basis of the transmitted first and second signals.

6. Method according to Claim 5, wherein a fault state in the first semiconductor switch (HS1) is furthermore detected by means of the central control unit (ZSE) if the actual switching state of the first semiconductor switch (HS1) is different from the reference switching state of the first semiconductor switch (HS1) and furthermore the actual switching state of the second semiconductor switch (HS2) matches the reference switching state of the second semiconductor switch (HS2), and wherein a fault state in the second semiconductor switch (HS2) is furthermore detected by means of the central control unit (ZSE) if the actual switching state of the second semiconductor switch (HS2) is different from the reference switching state of the second semiconductor switch (HS2) and moreover the actual switching state of the first semiconductor switch (HS1) matches the reference switching state of the first semiconductor switch (HS1) .

7. Method according to Claim 5 or Claim 6, wherein a switching request from the central control unit (ZSE) for a switching of an instantaneously open semiconductor switch of the first and second semiconductor switches (HS1, HS2) to the closed switching state is furthermore transmitted to the circuit arrangement (SA1, SA2) of the semiconductor switch (HS1, HS2) to be switched, and wherein, after the switching request has been received by the circuit arrangement (SA1, SA2) of the semiconductor switch (HS1, HS2) to be switched, a first time measurement of a time-measuring unit (ZME1, ZME3) of the circuit arrangement (SA1, SA2) is started, and wherein the actual switching state of the semiconductor switch (HS1, HS2) to be switched is determined after the start of the first time measurement, and wherein the determined actual switching state is transmitted via the signal line of the semiconductor switch (HS1, HS2) to be switched to the central control unit (ZSE) after a predefined time period following the start of the first time measurement.

8. Method according to Claim 7, wherein a second time measurement of a second time-measuring unit (ZME2) of the central control unit (ZSE) is furthermore started as soon as the switching request is made by the central control unit (ZSE), and wherein it is determined whether the actual switching state transmitted to the central control unit (ZSE) changes over from the open switching state to the closed switching state within a predefined time interval following the start of the second time measurement.

9. Method according to Claim 8, wherein a fault state is detected by the central control unit (ZSE) if the actual switching state transmitted to the central control unit (ZSE) does not change over from the open switching state to the closed switching state within the predefined time interval following the start of the second time measurement.

10. Method according to Claim 8 or Claim 9, wherein a fault state in the time-measuring unit (ZME1, ZME3) of the circuit arrangement (SA1, SA2) is detected by the central control unit (ZSE) if the actual switching state transmitted to the central control unit (ZSE) changes over from the open switching state to the closed switching state before the predefined time interval following the start of the second time measurement.

11. Circuit unit for determining fault states in a half-bridge circuit (HBS) having a first semiconductor switch (HS1) and a second semiconductor switch (HS2), wherein the first semiconductor switch (HS1) and the second semiconductor switch (HS2) are connected to one another in a series circuit and wherein the first semiconductor switch (HS1) and the second semiconductor switch (HS2) can in each case assume an open and a closed switching state, having:
- a first determination unit (E1) for determining an actual switching state of the first semiconductor switch (HS1),
- a second determination unit (E2) for determining an actual switching state of the second semiconductor switch (HS2),
- a central control unit (ZSE) for determining a reference switching state of the first semiconductor switch (HS1) and a reference switching state of the second semiconductor switch (HS2) and for controlling the first semiconductor switch (HS1) and the second semiconductor switch (HS2) in each case by means of a control signal,
- a fault determination unit (FE) for detecting a bridge short circuit in the half-bridge circuit (HBS) if the actual switching state of the first semiconductor switch (HS1) is different from the reference switching state of the first semiconductor switch (HS1) and moreover the actual switching state of the second semiconductor switch (HS2) is different from the reference switching state of the second semiconductor switch (HS2) .

12. Circuit unit according to Claim 11, furthermore having:
- a first circuit arrangement (SA1) for controlling the first semiconductor switch (HS1), wherein the first circuit arrangement (SA1) has the first determination unit (E1),
- a second circuit arrangement (SA2) for controlling the second semiconductor switch (HS2), wherein the second circuit arrangement (SA2) has the second determination unit (E2),
wherein the actual switching state of the first semiconductor switch (HS1) is transmittable by means of a first signal via a first signal line (S1) from the first circuit arrangement (SA1) to the central control unit (ZSE) and the actual switching state of the second semiconductor switch (HS2) is transmittable by means of a second signal via a second signal line (S2) from the second circuit arrangement (SA2) to the central control unit (ZSE), and wherein the central control unit (ZSE) has the fault determination unit (FE) and is designed to detect the bridge short circuit on the basis of the first and second signals.

13. Circuit unit according to Claim 12, wherein the central control unit (ZSE) is designed to detect a fault state in the first semiconductor switch (HS1) if the actual switching state of the first semiconductor switch (HS1) is different from the reference switching state of the first semiconductor switch (HS1) and moreover the actual switching state of the second semiconductor switch (HS2) matches the reference switching state of the second semiconductor switch (HS2), and wherein the central control unit (ZSE) is designed to detect a fault state in the second semiconductor switch (HS2) if the actual switching state of the second semiconductor switch (HS2) is different from the reference switching state of the second semiconductor switch (HS2) and moreover the actual switching state of the first semiconductor switch (HS1) matches the reference switching state of the first semiconductor switch (HS1).

14. Circuit unit according to Claim 12 or Claim 13, furthermore having:
- a first time-measuring unit (ZME1) to start a first time measurement after a switching request from the central control unit (ZSE) has been received by the first circuit arrangement (SA1) for a switching of the first semiconductor switch (HS1) to the closed switching state,
- a second time-measuring unit (ZME2) to start a second time measurement as soon as a switching request is made by the central control unit (ZSE) for a switching of the first semiconductor switch (HS1) or the second semiconductor switch (HS2) to the closed switching state,
- a third time-measuring unit (ZME3) to start a third time measurement after a switching request from the central control unit (ZSE) has been received by the second circuit arrangement (SA2) for a switching of the second semiconductor switch (HS2) to the closed switching state,
wherein the actual switching state of the first semiconductor switch (HS1) is transmittable by means of the first signal via the first signal line (S1) from the first circuit arrangement (SA1) to the central control unit (ZSE) after a predefined time period following the start of the first time measurement, and wherein the actual switching state of the second semiconductor switch (HS2) is transmittable by means of the second signal via the second signal line (S2) from the second circuit arrangement (SA2) to the central control unit (ZSE) after a predefined time period following the start of the third time measurement.

15. Circuit unit according to Claim 14, wherein the central control unit (ZSE) is designed to detect a fault state if the actual switching state of the first semiconductor switch (HS1) or the second semiconductor switch (HS2) transmitted to the central control unit (ZSE) does not change over from the open switching state to the closed switching state within a predefined time interval following the start of the second time measurement.

## Revendications

1. Procédé de détermination des états de défaut d'un circuit en demi-pont (HBS) qui possède un premier commutateur semiconducteur (HS1) et un deuxième commutateur semiconducteur (HS2), le premier commutateur semiconducteur (HS1) et le deuxième commutateur semiconducteur (HS2) étant branchés l'un à l'autre dans un circuit série et pouvant être commandés respectivement au moyen d'un signal de commande, et le premier commutateur semiconducteur (HS1) et le deuxième commutateur semiconducteur (HS2) pouvant respectivement adopter un état de commutation ouvert et un état de commutation fermé et le procédé comprenant les étapes suivantes :
- détermination d'un état de commutation réel et d'un état de commutation de consigne du premier commutateur semiconducteur (HS1),
- détermination d'un état de commutation réel et d'un état de commutation de consigne du deuxième commutateur semiconducteur (HS2),
- reconnaissance d'un court-circuit de pont au niveau du circuit en demi-pont (HBS) dans le cas où l'état de commutation réel du premier commutateur semiconducteur (HS1) est différent de l'état de commutation de consigne du premier commutateur semiconducteur (HS1) et, en plus, l'état de commutation réel du deuxième commutateur semiconducteur (HS2) est différent de l'état de commutation de consigne du deuxième commutateur semiconducteur (HS2).

2. Procédé selon la revendication 1, l'état de commutation de consigne du premier et du deuxième commutateur semiconducteur (HS1, HS2) étant fermé et l'état de commutation de consigne de l'autre commutateur semiconducteur du premier et du deuxième commutateur semiconducteur (HS1, HS2) étant ouvert et un court-circuit de pont au niveau du circuit en demi-pont étant reconnu dans le cas où l'état de commutation réel du commutateur semiconducteur fermé dans l'état de commutation de consigne est fermé et en plus l'état de commutation réel du commutateur semiconducteur ouvert dans l'état de commutation de consigne est fermé.

3. Procédé selon la revendication 1 ou la revendication 2, un nombre de courts-circuits de pont reconnus étant en outre déterminé et, dans le cas où le nombre déterminé de courts-circuits de pont reconnus dépasse une valeur de seuil prédéfinie, le premier commutateur semiconducteur (HS1) et le deuxième commutateur semiconducteur (HS2) étant commutés dans un état opérationnel prédéfini.

4. Procédé selon l'une des revendications précédentes, le premier commutateur semiconducteur (HS1) pouvant être attaqué au moyen d'un premier arrangement de circuit (SA1) et le deuxième commutateur semiconducteur (HS2) pouvant être attaqué au moyen d'un deuxième arrangement de circuit (SA2) et la détermination de l'état de commutation réel du premier commutateur semiconducteur (HS1) s'effectuant au moyen du premier arrangement de circuit (SA1) et la détermination de l'état de commutation réel du deuxième commutateur semiconducteur (HS2) s'effectuant au moyen du deuxième arrangement de circuit (SA2).

5. Procédé selon la revendication 4, l'état de commutation réel du premier commutateur semiconducteur (HS1) étant communiqué du premier arrangement de circuit (SA1) à une unité de commande centrale (ZSE) du circuit en demi-pont (HBS) au moyen d'un premier signal par le biais d'une première ligne de signal (S1) et l'état de commutation réel du deuxième commutateur semiconducteur (HS2) étant communiqué du deuxième arrangement de circuit (SA2) à l'unité de commande centrale (ZSE) au moyen d'un premier signal par le biais d'une deuxième ligne de signal (S2) et la reconnaissance du court-circuit de pont s'effectuant au moyen de l'unité de commande centrale (ZSE) en se basant sur les premier et deuxième signaux communiqués.

6. Procédé selon la revendication 5, un état de défaut du premier commutateur semiconducteur (HS1) étant en outre reconnu au moyen de l'unité de commande centrale (ZSE) dans le cas où l'état de commutation réel du premier commutateur semiconducteur (HS1) est différent de l'état de commutation de consigne du premier commutateur semiconducteur (HS1) et, en plus, l'état de commutation réel du deuxième commutateur semiconducteur (HS2) correspond à l'état de commutation de consigne du deuxième commutateur semiconducteur (HS2) et un état de défaut du deuxième commutateur semiconducteur (HS2) étant en outre reconnu au moyen de l'unité de commande centrale (ZSE) dans le cas où l'état de commutation réel du deuxième commutateur semiconducteur (HS2) est différent de l'état de commutation de consigne du deuxième commutateur semiconducteur (HS2) et, en plus, l'état de commutation réel du premier commutateur semiconducteur (HS1) correspond à l'état de commutation de consigne du premier commutateur semiconducteur (HS1) .

7. Procédé selon la revendication 5 ou la revendication 6, une demande de commutation de l'unité de commande centrale (ZSE) pour une commutation d'un commutateur semiconducteur momentanément ouvert parmi les premier et deuxième commutateurs semiconducteurs (HS1, HS2) dans l'état de commutation fermé étant en outre envoyée à l'arrangement de circuit (SA1, SA2) du commutateur semiconducteur (HS1, HS2) à commuter et, après la réception de la demande de commutation par l'arrangement de circuit (SA1, SA2) du commutateur semiconducteur (HS1, HS2) à commuter, une première mesure du temps d'une unité de mesure du temps (ZME1, ZME3) de l'arrangement de circuit (SA1, SA2) étant démarrée et l'état de commutation réel du commutateur semiconducteur (HS1, HS2) à commuter étant déterminé après le démarrage de la première mesure du temps et l'état de commutation réel déterminé étant communiqué à l'unité de commande centrale (ZSE) par le biais de la ligne de signal du commutateur semiconducteur (HS1, HS2) à commuter après une durée prédéterminée après le démarrage de la première mesure du temps.

8. Procédé selon la revendication 7, une deuxième mesure du temps d'une deuxième unité de mesure du temps (ZME2) de l'unité de commande centrale (ZSE) étant en outre démarrée dès que la demande de commutation de l'unité de commande centrale (ZSE) a eu lieu et un contrôle étant effectué afin de déterminer si l'état de commutation réel communiqué à l'unité de commande centrale (ZSE) change de l'état de commutation ouvert à l'état de commutation fermé au sein d'un intervalle de temps prédéterminé après le démarrage de la deuxième mesure du temps.

9. Procédé selon la revendication 8, un état de défaut étant reconnu par l'unité de commande centrale (ZSE) dans le cas où l'état de commutation réel déterminé communiqué à l'unité de commande centrale (ZSE) ne change pas de l'état de commutation ouvert à l'état de commutation fermé au sein de l'intervalle de temps prédéterminé après le démarrage de la deuxième mesure du temps.

10. Procédé selon la revendication 8 ou la revendication 9, un état de défaut de l'unité de mesure du temps (ZME1, ZME3) de l'arrangement de circuit (SA1, SA2) étant reconnu par l'unité de commande centrale (ZSE) dans le cas où l'état de commutation réel déterminé communiqué à l'unité de commande centrale (ZSE) change de l'état de commutation ouvert à l'état de commutation fermé avant le début de l'intervalle de temps prédéterminé après le démarrage de la deuxième mesure du temps.

11. Unité de circuit destinée à déterminer des états de défaut d'un circuit en demi-pont (HBS) qui possède un premier commutateur semiconducteur (HS1) et un deuxième commutateur semiconducteur (HS2), le premier commutateur semiconducteur (HS1) et le deuxième commutateur semiconducteur (HS2) étant branchés l'un à l'autre dans un circuit série et le premier commutateur semiconducteur (HS1) et le deuxième commutateur semiconducteur (HS2) pouvant respectivement adopter un état de commutation ouvert et un état de commutation fermé, comprenant :
- une première unité de détermination (E1) destinée à déterminer un état de commutation réel du premier commutateur semiconducteur (HS1),
- une deuxième unité de détermination (E2) destinée à déterminer un état de commutation réel du deuxième commutateur semiconducteur (HS2),
- une unité de commande centrale (ZSE) destinée à déterminer un état de commutation de consigne du premier commutateur semiconducteur (HS1) et un état de commutation de consigne du deuxième commutateur semiconducteur (HS2) et destinée à attaquer le premier commutateur semiconducteur (HS1) et le deuxième commutateur semiconducteur (HS2) au moyen d'un signal de commande,
- une unité de détermination de défaut (FE) destinée à reconnaître un court-circuit de pont au niveau du circuit en demi-pont (HBS) dans le cas où l'état de commutation réel du premier commutateur semiconducteur (HS1) est différent de l'état de commutation de consigne du premier commutateur semiconducteur (HS1) et, en plus, l'état de commutation réel du deuxième commutateur semiconducteur (HS2) est différent de l'état de commutation de consigne du deuxième commutateur semiconducteur (HS2).

12. Unité de circuit selon la revendication 11, comprenant en outre :
- un premier arrangement de circuit (SA1) destiné à attaquer le premier commutateur semiconducteur (HS1), le premier arrangement de circuit (SA1) possédant la première unité de détermination (E1),
- un deuxième arrangement de circuit (SA2) destiné à attaquer le deuxième commutateur semiconducteur (HS2), le deuxième arrangement de circuit (SA2) possédant la deuxième unité de détermination (E2),
l'état de commutation réel du premier commutateur semiconducteur (HS1) pouvant être communiqué du premier arrangement de circuit (SA1) à l'unité de commande centrale (ZSE) au moyen d'un premier signal par le biais d'une première ligne de signal (S1) et l'état de commutation réel du deuxième commutateur semiconducteur (HS2) pouvant être communiqué du deuxième arrangement de circuit (SA2) à l'unité de commande centrale (ZSE) au moyen d'un premier signal par le biais d'une deuxième ligne de signal (S2) et l'unité de commande centrale (ZSE) possédant l'unité de détermination de défaut (FE) et étant configurée pour reconnaître le court-circuit de pont en se basant sur les premier et deuxième signaux.

13. Unité de circuit selon la revendication 12, l'unité de commande centrale (ZSE) étant configurée pour reconnaître un état de défaut du premier commutateur semiconducteur (HS1) dans le cas où l'état de commutation réel du premier commutateur semiconducteur (HS1) est différent de l'état de commutation de consigne du premier commutateur semiconducteur (HS1) et, en plus, l'état de commutation réel du deuxième commutateur semiconducteur (HS2) correspond à l'état de commutation de consigne du deuxième commutateur semiconducteur (HS2) et l'unité de commande centrale (ZSE) étant configurée pour reconnaître un état de défaut du deuxième commutateur semiconducteur (HS2) dans le cas où l'état de commutation réel du deuxième commutateur semiconducteur (HS2) est différent de l'état de commutation de consigne du deuxième commutateur semiconducteur (HS2) et, en plus, l'état de commutation réel du premier commutateur semiconducteur (HS1) correspond à l'état de commutation de consigne du premier commutateur semiconducteur (HS1) .

14. Unité de circuit selon la revendication 12 ou la revendication 13, comprenant en outre :
- une première unité de mesure du temps (ZME1) destinée à démarrer une première mesure du temps après une réception d'une demande de commutation de l'unité de commande centrale (ZSE) par le premier arrangement de circuit (SA1) pour une commutation du premier commutateur semiconducteur (HS1) dans l'état de commutation fermé,
- une deuxième unité de mesure du temps (ZME2) destinée à démarrer une deuxième mesure du temps dès qu'une demande de commutation de l'unité de commande centrale (ZSE) pour une commutation du premier commutateur semiconducteur (HS1) ou du deuxième commutateur semiconducteur (HS2) dans l'état de commutation fermé a eu lieu,
- une troisième unité de mesure du temps (ZME3) destinée à démarrer une troisième mesure du temps après une réception d'une demande de commutation de l'unité de commande centrale (ZSE) par le deuxième arrangement de circuit (SA2) pour une commutation du deuxième commutateur semiconducteur (HS2) dans l'état de commutation fermé,
l'état de commutation réel du premier commutateur semiconducteur (HS1) pouvant être communiqué du premier arrangement de circuit (SA1) à l'unité de commande centrale (ZSE) au moyen du premier signal par le biais de la première ligne de signal (S1) après une durée prédéterminée après le démarrage de la première mesure du temps et l'état de commutation réel du deuxième commutateur semiconducteur (HS2) pouvant être communiqué du deuxième arrangement de circuit (SA2) à l'unité de commande centrale (ZSE) au moyen du deuxième signal par le biais de la deuxième ligne de signal (S2) après une durée prédéterminée après le démarrage de la troisième mesure du temps.

15. Unité de circuit selon la revendication 14, l'unité de commande centrale (ZSE) étant configurée pour reconnaître un état de défaut dans le cas où l'état de commutation réel du premier commutateur semiconducteur (HS1) ou du deuxième commutateur semiconducteur (HS2) communiqué à l'unité de commande centrale (ZSE) ne change pas de l'état de commutation ouvert à l'état de commutation fermé au sein d'un intervalle de temps prédéterminé après le démarrage de la deuxième mesure du temps.
